# EUROPÄISCHE PATENTSCHRIFT

(11) **EP 0 809 887 B1**
(45) Veröffentlichungstag und Bekanntmachung des Hinweises auf die Patenterteilung: **26.09.2001**
(21) Anmeldenummer: 96939108.5
(22) Anmeldetag: 21.11.1996
(51) Int. Cl.: H03K 17/687

(54) **SCHALTUNGSANORDNUNG ZUR ANSTEUERUNG EINER IMPULSENDSTUFE**
CIRCUIT CONFIGURATION FOR DRIVING A PULSE OUTPUT STAGE
CIRCUIT POUR LA COMMANDE D'UN ETAGE DE SORTIE D'IMPULSIONS

(30) Priorität: 13.12.1995 DE 19546562
(43) Veröffentlichungstag der Anmeldung: 03.12.1997
(73) Patentinhaber: Leica Geosystems AG, 9435 Heerbrugg (CH)
(72) Erfinder: RENZ, Norbert, 6900 Bregenz (AT)
(74) Vertreter: Stamer, Harald, Dipl,-Phys.
(86) Internationale Anmeldenummer: EP9605129
(87) Internationale Veröffentlichungsnummer: WO9722181

(56) Entgegenhaltungen:
- EP-A- 0 637 874
- DE-A- 3 301 648
- US-A- 5 089 727
- US-A- 5 463 648
- PROCEEDINGS OF THE INTERNATIONAL SYMPOSIUM ON POWER SEMICONDUCTOR DEVICES AND IC'S (ISPSD), TOKYO, MAY 19 - 21, 1992, Nr. SYMP. 4, 19.Mai 1992, INSTITUTE OF ELECTRICAL AND ELECTRONICS ENGINEERS, Seiten 194-197, XP000340035 KUMAGAI N: "GATE OPERATION CIRCUIT CONFIGURATION WITH A POWER SUPPLY FOR MOS-GATE DEVICES"

## Beschreibung

Die Erfindung betrifft eine Schaltungsanordnung zur Ansteuerung einer Impulsendstufe gemäß dem Oberbegriff des Anspruchs 1.

Derartige Endstufen liefern Spannungsimpulse mit geringem Innenwiderstand und ermöglichen beispielsweise die Energieversorgung von Verbrauchern, welche impulsförmig betrieben werden sollen. Solche Verbraucher können unter anderem auch Impulsdiodenlaser sein. Für Dioden im Leistungsbereich von einigen zehn Watt Spitzenleistung werden hier typischerweise Impulsströme bis zu 100 A bei Impulsbreiten von einigen zehn Nanosekunden benötigt. Für solche Endstufen werden häufig Thyristoren oder MOS-Feldeffekt-Leistungstransistoren (MOS-FET) eingesetzt, wobei letztere die Thyristoren durch ihren niedrigen Einschaltwiderstand immer mehr verdrängen.

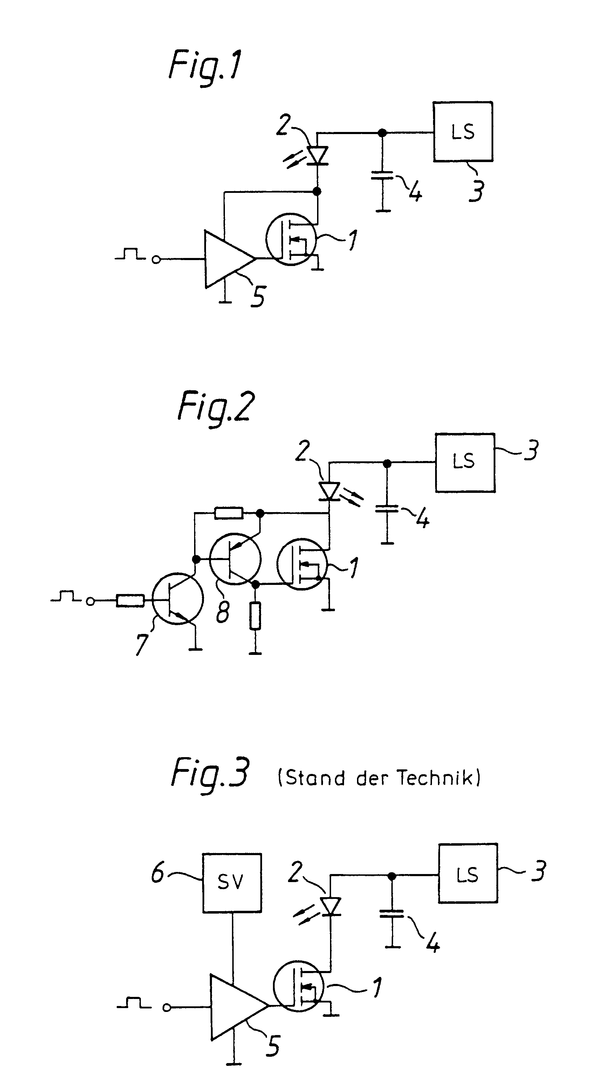

Eine Schaltungsanordnung zur Ansteuerung einer Impulsendstufe ist aus "Halbleiter Schaltungstechnik", Springer Verlag, 9. Auflage, Seite 581 bekannt und hier in Fig. 3, am Beispiel einer Endstufenansteuerung eines Diodenlasers zur Erläuterung dargestellt. Ein MOS-FET 1 schaltet direkt einen Diodenlaser (2) als Verbraucher an einen vorher durch eine nicht näher erläuterte Ladeschaltung (LS) 3 auf eine geeignet hohe Spannung aufgeladenen Kondensator (4). Dadurch wird der Kondensator (4) durch einen Stromimpuls über die Diode (2) und den MOS-FET (1) entladen, wobei sich die Spannungsabfälle über den beteiligten Bauteilen und Zuleitungen je nach ihrer Impedanz aufteilen. Es wird üblicherweise eine leistungsfähige Ansteuerung (5) verwendet, welche die großen Spitzenströme, die im Amperebereich liegen, liefert. Nachteilig daran ist, daß diese Ansteuerung sowohl eine eigene Spannungsversorgung (SV) 6 benötigt, was Zusatzkosten verursacht, als auch einen eigenen Energieverbrauch aufweist, was besonders bei kleinen und leichten tragbaren Geräten, insbesondere auch bei niedriger Batteriespannung, von Nachteil ist. Die eigene Spannungsversorgung (6) der Ansteuerung rührt daher, daß die zulässige Gate-Ansteuerspannung handelsüblicher MOS-FETs bei maximal 20 V liegt, und dann bei derartigen Endstufen in der Regel nur ein Bruchteil der an der Ladeschaltung zur Verfügung stehenden Spannung ist.

In der DE 33 01 648 A1 wird eine Leistungsstufe beschrieben, bei der dem Gate eines Leistungs-FET ein Eingangsverstärker vorgeschaltet ist. An den Eingangsverstärker wird das Ansteuersignal gelegt. Der Eingangsverstärker besteht aus zwei parallelgeschalteten FETs. Die Drainspannung des Leistungs-FET liegt am Drain eines der Verstärker-FET. Das Gate des Leistungs-FET ist mit den Source-Anschlüssen der Verstärker-FETs verbunden. Die an diesen erzeugte Ausgangsspannung folgt allein dem Ansteuersignal, solange die Spannung des Ansteuersignals die Drainspannung nicht überschreitet. Da Drain und Gate des Leistungs-FET über die Ansteuerschaltung nicht direkt verbunden sind, wird das Gate aktiv vor einer evtl. zu hohen Drainspannung geschützt.

Aufgabe der Erfindung ist es eine Schaltungsanordnung zur Ansteuerung einer Impulsendstufe der eingangs genannten Art zu schaffen, bei der die aus dem Stand der Technik bekannten Nachteile überwunden sind.

Diese Aufgabe wird bei einer gattungsgemäßen Schaltungsanordnung gemäß dem Oberbegriff des Anspruchs 1 durch die im Kennzeichen des Anspruchs 1 angegebenen Merkmale gelöst.

Gemäß der Erfindung kann die Endstufe ohne zusätzliche Hilfsspannung für die Ansteuerung versorgt werden, und auch ohne die hierfür notwendige Energie von einer Energiequelle direkt zu beziehen. Dadurch ergibt sich in besonders vorteilhafter Weise eine Kostenverringerung und eine/ Erhöhung des elektrischen Wirkungsgrads.

Erfindungsgemäß wird dies dadurch erreicht, daß eine geeignete Ansteuerung vom lastseitigen Ende der Endstufe her versorgt wird. Voraussetzung hierfür ist jedoch, daß die Spannungsabfälle aller am Stromfluß durch die Endstufe beteiligten Bauteile, einschließlich der Verdrahtungsimpedanzen, sich so aufteilen, daß der Spannungsabfall am Drain des MOS-FET das zulässige Spannungsmaximum am Gate des MOS-FET nicht überschreitet, um ihn nicht zu zerstören; denn es ist zu beachten, daß die Ladespannung der Impulsendstufe über dem zulässigen Spannungsmaximum des Gate liegt. Ein solcher Spannungsabfall am Drain entsteht bei den verlangten großen und kurzen Impulsströmen alleine schon durch die endliche Einschaltimpedanz des MOS-FET, was durch geeignete Auswahl der Bauteile, Schaltungsaufbau und Ladespannung noch zusätzlich beeinflußt werden kann.

Der an sich schädliche, aber nicht vermeidbare Spannungsabfall am Drain wird erfindungsgemäß zum Vorteil genutzt, da er sich unter den bereits oben erwähnten Einsatzbedingungen in einer Größenordnung bewegt, welche für eine getrennte Gateansteuerung ebenfalls nötig gewesen wäre. Der Durchschaltvorgang läuft auf die Weise ab, daß sich das Gate mittels der Ansteuerung vom Drain her auflädt und der MOS-FET durchzuschalten beginnt. Die Spannung am Gate gleicht sich nun der fallenden Spannung am Drain an und gleichzeitig wird das Gate vor der hohen Ladespannung bewahrt. Um einen möglichst großen Stromimpuls zu erhalten, ist, wie ebenfalls bereits erwähnt wurde, durch geeignete Auswahl der Bauteile, Schaltungsaufbau und Ladespannung, dafür zu sorgen, daß die Gatespannung möglichst hoch wird, aber das Gate gerade noch nicht beschädigt wird.

Eine vorteilhafte Weiterbildung des Endungsgegenstandes ist in dem Unteranspruch angegeben.

Der Erfindungsgegenstand wird im folgenden anhand von Ausführungsbeispielen unter Bezugnahme auf die Zeichnungen näher beschrieben, in denen
- Fig. 1: schematisch eine erste Ausführungsform der Erfindung zeigt,
- Fig. 2: die Ansteuerung bei der Ausführungsform gemäß Fig. 1 mehr im einzelnen zeigt, und
- Fig. 3: eine Ansteuerung einer Impulsendstufe nach dem Stand der Technik zeigt.

In den Figuren werden die gleichen Bezugszeichen für die gleichen Bauteile durchgehend verwendet.

Eine erste Ausführungsform einer Schaltungsanordnung einer Endstufenansteuerung nach der Erfindung wird unter Bezugnahme auf Fig. 1 beschrieben. Die in Fig. 1 gezeigte Schaltungsanordnung unterscheidet sich von der nach dem Stand der Technik gemäß Fig. 3 dadurch, daß die Spannungsversorgung (6) fortgelassen worden ist, und nunmehr die elektrische Energie für die Ansteuerung (5) von dem lastseitigen Ende der Endstufe zugeführt wird. Hierfür ist der Drain des MOS-FET (1) mit der Ansteuerung (5) verbunden.

Wie es bereits beschrieben worden ist, sollte die Gatespannung, um einen möglichst großen Stromimpuls zu erhalten, möglichst hoch sein, aber ohne bereits das Gate zu beschädigen. Als Gatespannungsversorgung kann der Spannungsabfall am Drain ausgenutzt werden, der bei den verlangten großen und kurzen Impulsströmen alleine schon durch die endliche Einschaltimpedanz des MOS-FET (1) entsteht. Dies kann durch eine geeignete Auswahl der Bauteile, des Schaltungsaufbaus und der Ladespannung abgestimmt werden.

Vorteilhaft bei dieser Schaltungsanordnung ist femer, daß der Strom aus der Ansteuerung, welcher an das Gate geliefert wird, ebenfalls durch den Verbraucher hindurch und nicht direkt aus einer Versorgungsspannung fließt, und so zum gesamten Stromfluß durch den Verbraucher beiträgt.

Eine mehr ins Einzelne gehende Darstellung der Anssteuerung 5 der Ausführungsform gemäß Fig. 1 ist beispielsweise in Fig. 2 gezeigt. Man erkennt, daß die Ansteuerung einen NPN-Transistor 7 und einen PNP-Transistor 8 umfaßt, die direkt hintereinander geschaltet und mit dem Gate des MOS-FET 1 gekoppelt sind.

Mit der in Fig. 2 gezeigten Schaltungsanordnung wurden bei der Verwendung eines MOS-FET kleiner Leistung und einer Ladespannung von 50 V Spitzenströme bis 100 A erreicht, wobei die Gatespannung auf 15V anstieg.

## Patentansprüche

1. Schaltungsanordnung zur Ansteuerung einer Impulsendstufe, die eine MOS-FET Leistungsstufe (1) und eine Ansteuerungsschaltung (5) umfaßt, wobei die MOS-FET Leistungsstufe (1) drain-seitig seriell mit einer Last (2) und einer Spannungsversorgung (3, 4) verbunden ist, **dadurch gekennzeichnet, daß** die Ansteuerungsschaltung (5) mit dem Drain des MOS-FET (1) als alleinige Spannungsversorgung verbunden ist und die Drainspannung direkt zum Gate des MOS-FET (1) durchschaltet, wobei die Schaltungs-Parameter im Lastkreis (1, 2, 4) derart ausgelegt sind, daß der Spannungsabfall am Drain des MOS-FET (1) im leitenden Zustand das zulässige Spannungsmaximum am Gate des MOS-FET (1) nicht überschreitet und der von dem Drain des MOS-FET (1) zu der Ansteuerungsschaltung (5) fließende Versorgungsstrom zu dem Laststrom beiträgt.

2. Schaltungsanordnung nach Anspruch 1, **dadurch gekennzeichnet, daß** die Ansteuerungsschaltung (5) einen Transistorschalter (8) als Schalter enthält.

## Claims

1. Circuit configuration for driving a pulse output stage, which comprises an MOS-FET power stage (1) and a drive circuit (5), the MOS-FET power stage (1) being connected on the drain side serially to a load (2) and a voltage supply (3, 4), **characterized in that** the drive circuit (5) is connected to the drain of the MOS-FET (1) as a sole voltage supply and the drain voltage is switched through directly to the gate of the MOS-FET (1), the circuit parameters in the load circuit (1, 2, 4) being designed so that the voltage drop at the drain of the MOS-FET (1) in the conducting state does not exceed the permissible maximum voltage at the gate of the MOS-FET (1) and the supply current flowing from the drain of the MOS-FET (1) to the drive circuit (5) contributes to the load current.

2. Circuit configuration according to Claim 1, **characterized in that** the drive circuit (5) contains a transistor switch (8) as a switch.

## Revendications

1. Circuit pour la commande d'un étage de sortie d'impulsion, comprenant un étage de puissance MOS-FET (1) et un circuit de commande (5), l'étage de puissance MOS-FET (1) étant relié en série, côté drain, à une charge (2) et à une alimentation en tension (3, 4), **caractérisé en ce que** le circuit de commande (5) est relié au drain du MOS-FET (1), à titre d'unique alimentation en tension, et la tension de drain est directement passée à la grille du MOS-FET (1), les paramètres de circuit dans le circuit de charge (1, 2, 4) étant tels que la chute de tension au drain du MOS-FET (1) à l'état conducteur ne dépasse pas le maximum admissible de tension à la grille du MOS-FET (1) et le courant d'alimentation, passant du drain du MOS-FET (1) au circuit de commande (5), contribuant au courant de charge.

2. Circuit selon la revendication 1, **caractérisé en ce que** le circuit de commande (5) contient un interrupteur à transistor (8), à titre d'interrupteur.
